# EUROPÄISCHE PATENTSCHRIFT

(11) **EP 4 147 006 B1**
(45) Veröffentlichungstag und Bekanntmachung des Hinweises auf die Patenterteilung: **26.02.2025**
(21) Anmeldenummer: 21725067.9
(22) Anmeldetag: 04.05.2021
(51) Int. Cl.: G01C 19/574, B81B 3/00

(54) **KOPPLUNGSVORRICHTUNG ZUM KOPPELN VON SCHWINGUNGSSYSTEMEN**
COUPLING DEVICE FOR COUPLING VIBRATION SYSTEMS
DISPOSITIF DE COUPLAGE SYSTÈMES DE VIBRATION

(30) Priorität: 06.05.2020 DE 102020112261
(43) Veröffentlichungstag der Anmeldung: 15.03.2023
(73) Patentinhaber: Northrop Grumman LITEF GmbH, 79115 Freiburg (DE)
(72) Erfinder: RENDE, Jan Daniel, 79336 Herbolzheim (DE)
(74) Vertreter: Müller Hoffmann & Partner
(86) Internationale Anmeldenummer: PCT/EP2021/061747
(87) Internationale Veröffentlichungsnummer: WO 2021/224273

(56) Entgegenhaltungen:
- DE-A1- 10 300 682
- US-A1- 2005 066 726
- US-A1- 2009 071 247

## Beschreibung

Die vorliegende Erfindung betrifft Kopplungsvorrichtungen zum Koppeln von Schwingungssystemen. Insbesondere betrifft die Erfindung mikro-elektro-mechanische Komponenten, wie etwa Inertialsensoren, insbesondere Drehratensensoren, mit mehreren Schwingungssystemen, die mechanisch gekoppelt sind.

Moderne mikro-elektro-mechanische Systeme (MEMS), wie etwa Inertialsensoren, insbesondere Drehratensensoren, weisen oft mehrere Schwingungssysteme auf, die im Gegentakt schwingen. Dies dient mitunter dazu, Kräfte und Drehmomente, die auf in den Schwingungssystemen vorhandene schwingende Massen einwirken derart symmetrisch auszubilden, dass das System zumindest im zeitlichen Mittel nach außen kräfte-und drehmomentenfrei ist.

Bekannt ist zum Beispiel, zwei Massen gegenläufig auf einer Linie zu führen. Für solche "Dual-Mass-Sensoren" sind verschieden Kopplungsmechanismen bekannt, die für eine im zeitlichen Mittel kräfte- und drehmomentenfreie Schwingung sorgen.

Ein Problem ergibt sich jedoch, wenn mehrere Schwingungssysteme verwendet werden sollen, die zwar entlang der gleichen Richtung schwingen, jedoch nicht in Schwingungsrichtung hintereinander sondern parallel angeordnet sind. Dies ist insbesondere für sogenannte "Quad Mass-Sensoren" der Fall, d.h. für Drehratensensoren, die vier schwingende Massen aufweisen. Diese sind zu zwei Dual-Mass-Sensoren gepaart, wobei jeder der Dual-Mass-Sensoren selbst in bekannter Weise gekoppelt werden kann. Neben der Kopplung der schwingenden Massen der einzelnen Dual-Mass-Sensoren im Gegentakt, sollen auch die Massen der beiden Dual-Mass-Sensoren stets im Gegentakt bewegt werden, da dadurch die Gesamtkräfte bzw. -drehmomente minimiert werden. Zudem soll die Bewegung sämtlicher Massen oft möglichst eindimensional erfolgen.

Aus der DE 103 00 682 A1, der US 2009/071247 A1 oder der US 2005/066726 A sind mittels Biegebalkenfedern gekoppelte Schwingungssysteme bekannt, die symmetrisch aufgebaut sind und gegenphasig schwingen können.

Aus dem Stand der Technik bekannte Lösungen zu diesem Problem koppeln die beiden Dual-Mass-Sensoren oft mittels Hebel- oder Wippenkonstruktionen miteinander. Derartige Konstruktionen haben jedoch den Nachteil, dass die Enden der Hebel aufgrund der starren Ausprägung der Hebel keine geradlinigen Bahnen beschreiben, sondern Kreisbahnen. Durch die Verwendung solcher Hebel werden die gekoppelten Schwingungssysteme also aus ihrer gewünschten linearen Bewegung gezogen, insbesondere für besonders bevorzugte größerer Auslenkungen der Schwingungssysteme. Hebelvorrichtungen für die Kopplung von Schwingungssystemen führen also systematisch zu einer ungewollten Ablenkung der schwingenden Massen von einer rein linearen Bewegung und können auch das Laufen der Massen im Gegentakt behindern. Diese systematischen Fehler führen zu einer Verschlechterung der Messresultate, die nur in aufwändiger Weise kompensiert werden können.

Aufgabe der vorliegenden Erfindung ist deshalb, eine Kopplungsvorrichtung zum Koppeln von mindestens zwei Schwingungssystemen anzugeben, mit der eine gegenläufige Bewegung der Schwingungssysteme verlässlich geführt werden kann. Eine weitere Aufgabe der Erfindung ist es, mikro-elektro-mechanische Komponenten, wie z.B. Inertial- /Drehratensensoren, bereitzustellen, die derartig gekoppelte Schwingungssysteme aufweisen. Diese Aufgabe ist durch den Gegenstand der Ansprüche gelöst.

Eine Kopplungsvorrichtung zum Koppeln einer Mehrzahl von Schwingungssystemen, die derart über einem Substrat gelagert sind, dass sie entlang einer ersten Richtung schwingen können und zueinander in einer zur ersten Richtung senkrechten zweiten Richtung versetzt sind, kann eine in die erste Richtung biegbare Biegebalkenfeder aufweisen, die mit den Schwingungssystemen verbunden werden kann. Hierbei sind Verbindungen der Biegebalkenfeder mit den Schwingungssystemen derart zwischen zumindest zwei Verbindungspunkten der Biegebalkenfeder mit dem Substrat angeordnet, dass eine durch Bewegungen der Schwingungssysteme hervorgerufene Auslenkung der Biegebalkenfeder zu einer Schwingung der Biegebalkenfeder mit Schwingungsbäuchen im Bereich der Verbindungen der Biegebalkenfeder mit den Schwingungssystemen führt.

Hierdurch wird erreicht, dass in y-Richtung benachbart angeordnete und mittels der Kopplungsvorrichtung gekoppelte Schwingungssysteme in ihrer Bewegung im Gegentakt stabilisiert werden, wenn durch diesen erst eine Schwingung der Biegebalkenfeder angeregt wurde, da die Schwingungssysteme mit dem Biegebalken im Bereich entgegengesetzt schwingender Schwingungsbäuche verbunden sind. Die Verbindungen sind hier optimaler Weise in den Punkten maximaler Auslenkung angeordnet. Hilfreich für die Anregung einer Schwingungsmode mit z.B. zwei Schwingungsbäuchen kann hierbei sein, wenn zwei Schwingungssysteme im Gegentakt mit der Eigenfrequenz der entsprechenden Schwingungsmode schwingen. Verallgemeinert man das System auf eine Mehrzahl von Schwingungssystemen, die über die Biegebalkenfeder gekoppelt sind, so ist eine Anordnung von Verbindungen zur Biegebalkenfeder und/oder eine Schwingungsanregung vorteilhaft, bei der im Bereich einer jeden Verbindungen ein Schwingungsbauch entsteht. In dieser Weise können Schwingungssysteme in effektiver Weise derart miteinander gekoppelt werden, dass eine Gegentaktbewegung von benachbarten Schwingungssystemen unterstützt werden kann. Zudem kann z.B. bei einer Verbindung von nur jedem übernächsten Schwingungsbauch der Biegebalkenfeder mit einem Schwingungssystem auch eine gleichlaufende Schwingung, bzw. bei unregelmäßiger Verteilung der Schwingungssysteme eine gemischt gegen- und gleichläufige Schwingung erreicht werden.

Eine erfindungsgemäße mikro-elektro-mechanische Komponente, vorzugsweise ein Inertialsensor, weiter vorzugsweise ein Drehratensensor zum Messen einer Drehung des Drehratensensors weist die Kopplungsvorrichtung wie sie oben beschrieben wurde und die Mehrzahl der Schwingungssysteme auf. Gemäß einer ersten erfindungsgemäßen Lösung beträgt die Anzahl der Schwingungssysteme N und eine Länge der Biegebalkenfeder zwischen zwei Verbindungspunkten zum Substrat L. Das Schwingungssystem n (n=1, ..., N) ist dann bei (2n-1)·L/2N mit der Biegebalkenfeder verbunden. Hierdurch wird die Ausbildung von N Schwingungsbäuchen und damit die Gegentaktkopplung vereinfacht.

Alternativ kann die Kopplungsvorrichtung mindestens ein erstes Schwingungssystem und ein zweites Schwingungssystem miteinander koppeln. Die Biegebalkenfeder erstreckt sich hierbei entlang der zweiten Richtung und kann an mindestens drei Verbindungspunkten mit dem Substrat, zwischen einem Paar von benachbarten Verbindungspunkten mit dem ersten Schwingungssystem und zwischen dem anderen Paar von benachbarten Verbindungspunkten mit dem zweiten Schwingungssystem verbunden werden. Hierbei ist die Kopplungsvorrichtung geeignet, gegenläufige Schwingungen des ersten Schwingungssystems und des zweiten Schwingungssystems entlang der ersten Richtung gekoppelt zu führen.

Insbesondere kann eine mikro-elektro-mechanische Komponente, wie etwa ein Inertialsensor oder ein Drehratensensor zum Messen einer Drehung des Drehratensensors bzw. eines mit dem Drehratensensor verbundenen Objekts die oben beschriebene Kopplungsvorrichtung sowie das erste Schwingungssystem und das zweite Schwingungssystem aufweisen. Die Kopplungsvorrichtung ist hierbei an drei Verbindungspunkten mit dem Substrat verbunden und zwischen einem Paar von benachbarten Verbindungspunkten mit dem ersten Schwingungssystem verbunden und zwischen dem anderen Paar von benachbarten Verbindungspunkten mit dem zweiten Schwingungssystem verbunden.

Eine mikro-elektro-mechanische Komponente, wie etwa ein Drehratensensor weist also zwei schwingende Systeme auf, die für die Funktion der mikro-elektro-mechanischen Komponente benötigt werden, z.B. für die Bestimmung der Drehrate des Sensors. Diese können im Prinzip beliebig ausgebildet sein, solange sie in einer ersten Richtung gegenläufig Schwingungen ausführen können und mit Versatz in einer anderen, hierzu senkrechten zweiten Richtung nebeneinander angeordnet sind. Die Bewegungslinien der Schwingungssysteme können hierbei versetzt oder sogar verkippt zueinander sein. Die beiden schwingenden Systeme können z.B. Dual-Mass-Drehratensensoren sein, die zu einem Quad-Mass-Sensor verbunden sind.

Im Gegensatz zum Stand der Technik wird kein starrer Hebel verwendet, um die beiden Schwingungssysteme miteinander zu verbinden, sondern eine Kopplungsvorrichtung mit einer Biegebalkenfeder. Diese ist an drei Stellen mit dem Substrat des Sensors verbunden. Zwischen diesen Verbindungspunkten befindet sich jeweils die Verbindung zu den Schwingungssystemen, bevorzugt in der Mitte zwischen den Verbindungspunkten.

Wird nun in einem (oder beiden) der Schwingungssysteme eine Schwingung in die erste Richtung angeregt, wird der Teil der Biegebalkenfeder, der mit dem Schwingungssystem verbunden ist, entsprechend in die erste Richtung gezogen, während er an den beiden Verbindungspunkten zum Substrat im Wesentlichen feststeht. Aufgrund der eindimensionalen Auslenkbarkeit der Biegebalkenfeder wird dadurch der Bereich mit der Verbindung zum anderen Schwingungssystem in die entgegengesetzte Richtung bewegt, bzw. eine entsprechende im Schwingungssystem angeregte Bewegung wird unterstützt und stabilisiert. Die Kopplungsvorrichtung ist also geeignet, die Schwingungssysteme gekoppelt zu führen.

Ausschlaggebend ist hierbei die Verwendung der Biegebalkenfeder als Kopplungselement, da die Verformbarkeit der Biegebalkenfeder in die erste Richtung eine lineare Bewegung ohne kreisförmigen Anteil ermöglicht. Dies ist mit einem Hebelmechanismus, wie er aus dem Stand der Technik bekannt ist, nicht möglich. Aus diesem Grund erlaubt die Biegebalkenfeder auch größere Auslenkungen der Schwingungssysteme als ein Hebelmechanismus, da die Abweichung von der linearen Bewegung bei der Verwendung von Hebeln umso deutlicher wird, je größer die Bewegung des Hebels ist. Dies beschränkt die technisch sinnvolle Auslenkung der gekoppelten Schwingungssysteme, eine Einschränkung die für die Biegebalkenfeder prinzipiell nicht auftritt.

Die Verwendung einer geeigneten mit dem Substrat verbundenen Biegebalkenfeder ermöglicht es also, eine Kopplung zwischen zwei Schwingungssystemen zu realisieren, die nicht zu einer Abweichung der Schwingungssysteme von der beabsichtigten gegenläufigen Bewegung führt. Dadurch steigt die Verlässlichkeit des Sensors. Zudem können die Schwingungssysteme mit größerer Amplitude schwingen, wodurch sich die Signalstärke der gemessenen Signale erhöht. Dies führt wiederum zu empfindlicheren Sensoren.

Die Kopplungsvorrichtung kann bei gegenläufigen Schwingungen des ersten Schwingungssystems und des zweiten Schwingungssystems entlang der ersten Richtung diese zu einer Bewegung im Gegentakt, vorzugsweise zu einer parallelen Bewegung zwingen. Es wird also eine streng gegenläufige Bewegung unterstützt bzw. herbeigeführt. Zudem können von der ersten Richtung abweichende Bewegungskomponenten durch die Auslenkung der Biegebalkenfeder reduziert bzw. gelöscht werden. Die Kopplungsvorrichtung kann die beiden Schwingungssysteme dadurch auf parallele Bewegungsbahnen zwingen. Durch diese Maßnahmen kann das Schwingungsverhalten weiter verbessert werden, wodurch die mikro-elektro-mechanische Komponente verlässlicher wird.

Die Kopplungsvorrichtung kann das erste und das zweite Schwingungssystem zu Schwingungen mit betragsmäßig gleich großer Amplitude und gegenläufiger Richtung zwingen. Dadurch wird sichergestellt, dass die gekoppelten Schwingungssysteme möglichst kräfte- und drehmomentenfrei ist, da sich Federkräfte und Drehmomente, die im ersten Schwingungssystem auftreten, mit Federkräften und Drehmomenten kompensieren, die im zweiten Schwingungssystem auftreten, wenn beide Schwingungen genau im Gegentakt, d.h. mit gleichem Amplitudenbetrag aber entgegengesetzter Auslenkung entlang der ersten Richtung schwingen.

Die Kopplungsvorrichtung gemäß einer zweiten erfindungsgemäßen Lösung weist ein erstes, ein zweites und ein drittes Drehfederelement auf. Hierbei verbindet das erste Drehfederelement ein erstes Ende der Biegebalkenfeder, das zweite Drehfederelement die Mitte der Biegebalkenfeder und das dritte Drehfederelement ein zweites Ende der Biegebalkenfeder mit dem Substrat. Zudem ist das erste Schwingungssystem in der Mitte zwischen erstem und zweitem Drehfederelement und das zweite Schwingungssystem in der Mitte zwischen zweitem und drittem Drehfederelement mit der Biegebalkenfeder verbunden. Dadurch bildet sich bei einer gegenläufigen Auslenkung des ersten und zweiten Schwingungssystems entlang der ersten Richtung die zweite Eigenmode der Biegebalkenfeder als erste Eigenmode der Kopplungsvorrichtung aus und zwingt das erste und zweite Schwingungssystem zu der gegenläufigen, vorzugsweise parallelen, Bewegung.

Durch die Verwendung von Drehfederelementen für die Verbindung zwischen Biegebalkenfeder und Substrat wird die Biegebalkenfeder in den Verbindungspunkten drehbar gelagert. Hierdurch kann sich die Biegebalkenfeder in den Verbindungspunkten stärker in Richtung der Auslenkung des benachbarten Schwingungssystems verbiegen. Die Biegebalkenfeder nimmt also für die Kopplung eine S-förmige Gestalt an, da sie an ihren Endpunkten und ihrem Mittelpunkt (im Wesentlichen) räumlich feststehend, aber drehbar mit dem Substrat verbunden ist. Diese S-förmige Gestalt entspricht der zweiten Eigenmode einer frei schwingenden Biegebalkenfeder. Im Folgenden soll auch eine aus mehreren Segmenten bestehende Biegebalkenfeder, die z.B. durch die Drehfederelemente unterteilt ist, als eine einzelne Biegebalkenfeder verstanden werden. Der Bezug auf die zweite Eigenmode oben betrifft also den gesamten zwischen den äußeren Verbindungspunkten liegenden Teil der Biegebalkenfeder.

Die Mittelpunkte zwischen den Verbindungen zum Substrat bilden hierbei Punkte größter Auslenkung, die zudem gegengleiche Amplituden aufweisen und sich rein geradlinig und parallel bewegen. Die Bewegung der Biegebalkenfeder kann hierbei insbesondere einer stehenden Welle mit fixen Endpunkten und fixem Mittelpunkt entsprechen.

Da die Schwingungssysteme an den Punkten größter Auslenkung mit der Biegebalkenfeder verbunden sind, werden die Bewegungen der Schwingungssysteme ebenfalls auf lineare und parallele Bahnen gezwungen. Die Verwendung von Drehfedern verbessert also die geführte Auslenkung der Schwingungssysteme und damit die Verlässlichkeit und Genauigkeit des Drehratensensors.

Bei gegenläufiger Auslenkung des ersten und des zweiten Schwingungssystems können Kräfte auf die Biegebalkenfeder ein erstes Drehmoment M1 an dem ersten Drehfederelement, ein zweites Drehmoment M2 an dem zweiten Drehfederelement und ein drittes Drehmoment M3 an dem dritten Drehfederelement erzeugen. Das erste Drehfederelement kann eine erste Federkonstante K1 gegenüber Drehungen, das zweite Drehfederelement eine zweite Federkonstante K2 gegenüber Drehungen und das dritte Drehfederelement eine dritte Federkonstante K3 gegenüber Drehungen aufweisen, wobei die Beziehung gilt: K1:K2:K3 = M1:M2:M3.

Das zwischen erstem und zweitem Drehfederelement verbundene erste Schwingungssystem übt aufgrund der darin angeregten Schwingung eine Kraft auf die Biegebalkenfeder aus. Diese Kraft wird über die Biegebalkenfeder auf das erste Drehfederelement und das zweite Drehfederelement weitergeleitet und erzeugt dort jeweils ein Drehmoment. In entgegengesetzter Richtung übt das zweite Schwingungssystem eine entgegengesetzte Kraft auf das zweite und das dritte Drehfederelement aus und erzeugt dort ebenfalls Drehmomente. Diese Drehmomente müssen von den Drehfederelementen aufgefangen werden, was zu Verformungen der Drehfederelemente führt, insbesondere zu einer Verdrehung. Um eine besonders symmetrische Verbiegung der Biegebalkenfeder zu erreichen, sollten die Federkonstanten gegenüber Drehungen, d.h. die Drehsteifigkeit der Drehfederelemente gegenüber diesen Verformungen im gleichen Verhältnis zueinander stehen, wie die von den Schwingungssystemen insgesamt auf die Drehfederelemente ausgeübten Drehmomente.

Insbesondere können das erste und dritte Drehfederelement die gleiche Federkonstante gegenüber Drehungen K1 = K3 aufweisen und das zweite Drehfederelement kann eine Federkonstante gegenüber Drehungen K2 aufweisen, die doppelt so groß ist, wie die Federkonstante der äußeren Drehfederelemente, d.h. es gilt K1:K2:K3 = 1:2:1. Dies bietet sich insbesondere für einen symmetrischen Aufbau an, in dem die Schwingungssysteme genau in der Mitte zwischen zwei Drehfederelementen mit der Biegebalkenfeder verbunden sind und die beiden Abschnitte der Biegebalkenfeder zwischen dem mittleren Drehfederelement und den beiden äußeren Drehfederelementen gleich sind. In diesem Fall doppeln sich die auf das mittlere, d.h. zweite Drehfederelement wirkenden Drehmomente gegenüber den außen wirkenden Drehmomenten auf. Dem kann durch das besonders einfache Verhältnis K1:K2:K3 = 1:2:1 begegnet werden, für das sich in diesem Fall für die Schwingungssysteme eine genau gleichlaufende Bewegung im Gegentakt ergibt.

Die Drehfederelemente können sowohl gegenüber dem Substrat verdreht als auch linear gegenüber dem Substrat bewegt werden. Dies kann dann Sinn machen, wenn die Biegebalkenfeder nicht dehnbar genug ist, die aufgrund der Verformung und der festen Verbindung mit dem Substrat notwendige Längenänderung bereitstellen zu können. In diesem Fall kann das Drehfederelement neben einer Rotation auch eine Verformung entlang der zweiten Richtung erzeugen, wodurch sich die zwischen den Drehfederelementen liegenden Abschnitte der Biegebalkenfeder "verlängern". Die Biegebalkenfeder besteht dann nicht aus einem durchgängigen Biegebalken, sondern aus zwei (oder mehr) Teilstücken, die an ihrem Enden mit den Drehfederelementen verbunden sind. Beide Teilstücke zusammen werden hier als Biegebalkenfeder bezeichnet.

Die lineare Verformbarkeit der Drehfederelemente führt also zu einer linearen Verschiebung des Verbindungspunkts zwischen Biegebalkenfeder und Drehfederelement gegenüber dem Substrat. Dadurch können auch Biegebalken verwendet werden, die sich ohne Längenänderung verformen, da die erforderliche Längenänderung durch die Verschiebung des Verbindungspunktes ersetzt wird. Dies erlaubt es, die mikro-elektro-mechanische Komponente aus einem Material herzustellen, das für deren Funktionsfähigkeit von Vorteil ist, ohne auf seine elastischen Eigenschaften Rücksicht nehmen zu müssen. Es wird also auch hierdurch die Verlässlichkeit der mikro-elektro-mechanischen Komponente verbessert.

Die Drehfederelemente können eine Größe von weniger als 1000 µm, 500 µm, 150 µm, 100 µm, 50 µm, 30 µm, 10 µm, oder 5 µm aufweisen. Je kleiner die Drehfederelemente sind, desto näher kommt die erste Eigenmode der Kopplungsvorrichtung einer Sinusschwingung mit genau parallelen und gegenläufig wandernden Punkten maximaler Auslenkung. Kleinere Drehfederelemente verbessern also die Auslenkung der Schwingungssysteme und damit die Verlässlichkeit der mikro-elektro-mechanischen Komponente.

Die Verbindungen zwischen dem ersten und dem zweiten Schwingungssystem und der Kopplungsvorrichtung entlang der zweiten Richtung können eine Breite aufweisen, die kleiner als 250 µm, 200 µm, 150 µm, 100 µm, 50 µm, 30 µm, 10 µm, 5 µm oder 1 µm ist. Im Bereich der Verbindungen zu den Schwingungssystemen ist die Verformbarkeit der Biegebalkenfeder verändert. Je schmaler dieser Bereich ist, d.h. je einheitlicher die Verformbarkeit der Biegebalkenfeder ist, desto reiner kann sich eine Sinusschwingung ausbilden, was aus den oben genannten Gründen die mikro-elektro-mechanische Komponente verbessert.

Die mikro-elektro-mechanische Komponente kann eine weitere Kopplungsvorrichtung aufweisen, die identisch zu der zuvor beschriebenen Kopplungsvorrichtung aufgebaut ist. Hierbei sind das erste und das zweite Schwingungssystem entlang der ersten Richtung zwischen den beiden Kopplungsvorrichtungen angeordnet und die beiden Kopplungsvorrichtungen sind in gleicher Weise mit dem ersten und dem zweiten Schwingungssystem verbunden. Die Führung oder Kopplung der Schwingungssysteme findet also von zwei entlang der Schwingungsrichtung gegenüberliegenden Seiten aus statt. Dadurch werden die Führung und damit die Linearität der Schwingung verbessert.

Das erste und das zweite Schwingungssystem können jeweils zwei Massen aufweisen, die entlang der ersten Richtung zu gegenläufigen Schwingungen angeregt werden können. Eine Drehung bei angeregter Schwingung entlang der ersten Richtung löst eine auf die Massen wirkende Corioliskraft entlang der zweiten Richtung aus, deren Größe gemessen werden kann, um auf die Drehrate zu schließen. Das erste und das zweite Schwingungssystem haben einen identischen und symmetrischen Aufbau, aufgrund dessen die mikro-elektro-mechanische Komponente als Ganzes bei angeregten Schwingungen der Massen zumindest im zeitlichen Mittel kräfte- und drehmomentenfrei ist.

Die beiden Schwingungssysteme sind also als Dual-Mass-Drehratensensoren mit zwei Massen ausgebildet, die innerhalb eines Schwingungssystems zu Schwingungen im Gegentakt angeregt werden können. Zudem schwingen die Massen der beiden Dual-Mass-Sensoren auch in Beziehung zueinander im Gegentakt. Nach außen wirkende Kräfte sind dann immer durch entsprechend große, nach innen wirkende Kräfte kompensiert. Eine Drehung des durch diese Anordnung erzeugten Quad-Mass-Drehratensensors führt dabei zu Corioliskräften auf alle Massen. Auch diese Kräfte kompensieren sich genau. Im zeitlichen Mittel ist der Drehratensensor also kräfte- und drehmomentenfrei. Dies wird durch die oben beschriebenen Kopplungsvorrichtungen unterstützt, da diese für eine gekoppelte, lineare Bewegung im Gegentakt sorgen.

Die vorliegende Erfindung soll im Folgenden mit Bezug auf die beigefügten Figuren näher beschrieben werden. Diese Beschreibung ist aber rein beispielhaft. Die Erfindung ist nur durch den Gegenstand der Ansprüche definiert. Es zeigt:
- **Fig. 1A und 1B**: schematische Darstellungen einer Kopplungsvorrichtung;
- **Fig. 2**: eine schematische Darstellung einer Kopplungsvorrichtung;
- **Fig. 3**: eine schematische Darstellung eines Drehfederelements;
- **Fig. 4**: eine schematische Darstellung eines Drehratensensors; und
- **Fig. 5A und 5B**: schematische Darstellungen eines weiteren Drehratensensors.

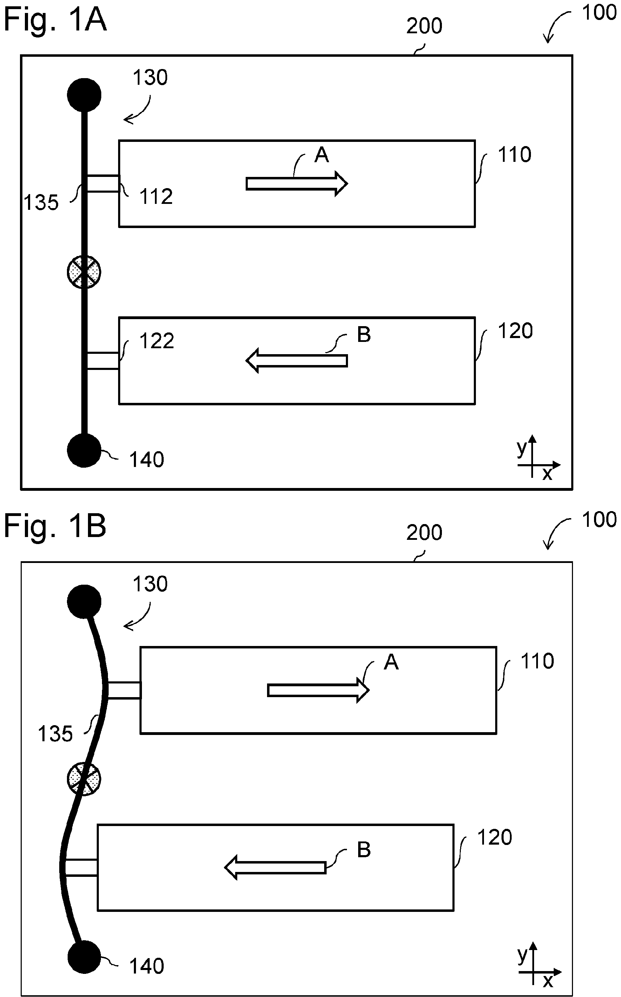

Die Fig. 1A und 1B zeigen in schematischer Weise eine mikro-elektro-mechanische Komponente, wie etwa einen Inertialsensor oder einen Drehratensensor 100, die als mikro-elektro-mechanische Systeme (MEMS) ausgebildet sind. Im Folgenden wird zur Vereinfachung stets auf einen Drehratensensor 100 Bezug genommen, ohne dass dies jedoch als einschränkend gelten soll.

Der Drehratensensor 100 ist in der Lage, Drehungen um eine zur Bildebene senkrechte Achse zu detektieren. Hierzu weist der Drehratensensor 100 ein erstes Schwingungssystem 110 und ein zweites Schwingungssystem 120 auf, die über einem Substrat 200 des Drehratensensors 100 gelagert sind.

Diese beiden Schwingungssysteme 110, 120 sind in den Fig. 1A und 1B stark schematisiert dargestellt. Beide Schwingungssysteme 110, 120 weisen Komponenten auf, die mit Bezug auf das Substrat in eine erste Richtung beweglich sind, wie in den Fig. 1A und 1B durch die Pfeile A und B dargestellt. Die erste Richtung entspricht in den Fig. 1A und 1B der x-Richtung bzw. der x-Achse. Die Bewegung der Komponenten der Schwingungssysteme 110, 120 entlang der x-Richtung ermöglicht es, in bekannter Weise Drehraten über die Auswirkungen der Corioliskraft zu bestimmen, entweder für jedes Schwingungssystem 110, 120 separat oder durch die Kombination beider Schwingungssysteme 110, 120. Da dies hinlänglich bekannt ist, braucht die innere Struktur der Schwingungssysteme 110, 120 hier nicht näher erläutert werden. Sie kann im Prinzip jeder beliebigen zur Drehratenmessung geeigneten Struktur entsprechen. Auch können Schwingungssysteme mit ähnlichem Bewegungsverlauf in anderen mikro-elektro-mechanische Komponenten enthalten sein, die einen anderen Zweck erfüllen.

Ausschlaggebend ist, dass das erste Schwingungssystem 110 und das zweite Schwingungssystem 120 für einen optimalen Betrieb der mikro-elektro-mechanischen Komponente bzw. des Drehratensensors 100 gegenläufig entlang der ersten Richtung x ausgelenkt werden müssen. "Gegenläufig" schließt hier sowohl entgegengesetzte Bewegungen rein in x-Richtung, als auch entgegengesetzte Bewegungen ein, die gegen die x-Richtung und zueinander verkippt sind. Vorzugsweise laufen aber beide Schwingungssysteme linear und parallel entlang der x-Richtung. Das heißt, während das erste Schwingungssystem 110 (oder für die Drehratenmessung relevante Teile daraus) sich in der Fig. 1A nach rechts bewegt, bewegt sich das zweite Schwingungssystem 120 (oder für die Drehratenmessung relevante Teile daraus) nach links und umgekehrt. Obwohl die jeweiligen Bewegungen bzw. Schwingungen der Schwingungssysteme 110, 120 durch in den Schwingungssystemen 110, 120 angeordnete Mechanismen, wie z.B. Treiberelektrodenpaare, angeregt werden können, ist eine mechanische Kopplung zwischen den schwingenden Körpern von Vorteil um die gegenläufige Bewegung, wenn möglich im Gegentakt, sicher zu führen.

Wie in der Fig. 1A zu sehen, sind das erste und das zweite Schwingungssystem 110, 120 senkrecht zur ersten Richtung, d.h. entlang der y-Richtung, nebeneinander angeordnet, d.h. sie liegen parallel zueinander und sind in y-Richtung zueinander versetzt. Aus dem Stand der Technik bekannte Kopplungsmechanismen, die für eine Kopplung entlang der Bewegungsrichtung von Schwingungen geeignet sind, können deshalb für Drehratensensoren 100, wie sie vorliegend von Interesse sind, nicht eingesetzt werden. Die Kopplung muss vielmehr über eine Kopplungsvorrichtung 130 erfolgen, die sich entlang der y-Richtung, d.h. entlang einer zur ersten Richtung senkrechten, zweiten Richtung erstreckt. Die Kopplungsvorrichtung 130 muss hierbei nicht rein linear bzw. geradlinig der zweiten Richtung folgen, sondern kann auch Segmente aufweisen, die bezüglich der zweiten Richtung geneigt sind, also z.B. schräg oder sogar senkrecht zur zweiten Richtung laufen. Ausschlaggebend ist, dass die Kopplungsvorrichtung 130 in der Lage ist, Schwingungssysteme 110, 120 miteinander zu koppeln, die in y-Richtung versetzt angeordnet sind.

Um diese Kopplung zu ermöglichen, muss die innerhalb der Schwingungssysteme 110, 120 stattfindende Bewegung, von außerhalb der Schwingungssysteme 110, 120 mechanisch erfassbar sein, da ansonsten eine Verbindung zur Kopplungsvorrichtung 130 nicht möglich ist. Dies ist in den Fig. 1A und 1B durch die Verschiebung des gesamten, das Schwingungssystem 110, 120 darstellenden Blocks abgebildet. Dies dient aber nur der Vereinfachung der Beschreibung und darf nicht als einschränkend verstanden werden. Wann immer im Folgenden von der Bewegung oder Schwingung eines Schwingungssystems 110, 120 oder dessen Verbindung zur Kopplungsvorrichtung 130 gesprochen wird, soll dies als Aussage über die sich innerhalb des Schwingungssystems 110, 120 bewegenden Komponenten verstanden werden, die von der Kopplungsvorrichtung 130 in Gegentakt gebracht werden sollen.

Wie in den Fig. 1A und 1B dargestellt weist die Kopplungsvorrichtung 130 eine Biegebalkenfeder 135 auf, die mit den Schwingungssystemen 110, 120 verbunden ist. Die Biegebalkenfeder 135 ist hierbei in der Lage, in x-Richtung ausgelenkt zu werden. Sie weist in x-Richtung eine Steifigkeit auf, die kleiner sein kann als die Steifigkeiten gegenüber Bewegungen in andere Richtungen. Die Biegebalkenfeder 135 kann hierbei aus mehreren Segmenten, z.B. aus mehreren Biegebalken, zusammengesetzt sein und prinzipiell auch Teilabschnitte aufweisen, die senkrecht zur x-Richtung verformt werden können, um z.B. eine Längenänderung der Biegebalkenfeder 135 herbeizuführen.

Die Biegebalkenfeder 135 kann an mindestens drei Verbindungspunkten 140 mit dem Substrat 200 verbunden sein, d.h. an den Verbindungspunkten 140 ist die Beweglichkeit der Biegebalkenfeder 135 in die x- und die y-Richtung stark eingeschränkt. Im Idealfall kann sich die Biegebalkenfeder 135 in den Verbindungspunkten 140 nicht in die x- und y-Richtungen bewegen. Die Biegebalkenfeder 135 kann aber idealer Weise über den Verbindungspunkten 140 noch gedreht werden. Der mittlere, schraffiert gezeigte Verbindungspunkt 140 kann hierbei aber im Prinzip auch weggelassen werden.

Zwischen je zwei Paaren der drei Verbindungspunkte 140 befinden sich Verbindungen 112, 122 zu den beiden Schwingungssystemen 110, 120. Die Verbindungen können hierbei jede beliebige Gestalt aufweisen, die für eine Verbindung von Biegebalkenfeder 135 und Schwingungssystemen 110, 120 vorteilhaft ist. Zum Beispiel kann die Biegebalkenfeder 135 im Bereich der Verbindungen 112, 122 auch massiver oder flexibler sein als in anderen Bereichen oder mit mehreren, gegebenenfalls parallelen Segmenten ausgebildet sein. Auch kann die Biegebalkenfeder 135 im Bereich der Verbindungen 112, 122 gerade oder gebogen sein, wenn dies eine verbesserte Verbindung zu den Schwingungssystemen 110, 120 erlaubt.

Eine Auslenkung der Schwingungssysteme 110, 120 führt, wie in der Fig. 1B gezeigt, zu einer Ausbauchung der Biegebalkenfeder 135 in Richtung der Auslenkung. Durch die drehbare Verbindung der Biegebalkenfeder 135 mit dem Substrat führt eine Auslenkung nach rechts in der oberen Hälfte der Biegebalkenfeder 135 zu einer Auslenkung nach links in der unteren Hälfte. Dies liegt daran, dass durch die drehbare Lagerung im mittleren Verbindungspunkt 140 in diesem Bereich keine Kraft auf die Biegebalkenfeder 135 einwirkt, die zu einer Abweichung von einem in erster Ordnung geradlinigen Verlauf der Biegebalkenfeder 135 in diesem Bereich führt. Die Biegebalkenfeder 135 ist aber am unteren Verbindungspunkt 140 fixiert.

Zieht das erste Schwingungssystem 110 die Biegebalkenfeder 135 nun in ihrer oberen Hälfte nach rechts, verbiegt sich die Biegebalkenfeder 135 derart, dass sie in ihrem mittleren Bereich im Wesentlichen geradlinig von rechts oben nach links unten läuft, um sich dann in Richtung des unteren Verbindungspunkts 140 nach rechts zurück zu biegen. Die Biegebalkenfeder 135 baucht sich im unteren Bereich also nach links aus und zwingt das zweite Schwingungssystem 120 dieser Bewegung zu folgen, wie in der Fig. 1B gezeigt. Auf diese Weise führt die Kopplungsvorrichtung die beiden Schwingungssysteme 110, 120 in ihrer gegenläufigen Bewegung, idealer Weise stets im Gegentakt.

Vorteilhaft ist hierbei ein symmetrischer Aufbau wie in den Fig. 1A und 1B gezeigt, bei dem die äußeren Verbindungspunkte 140 mit den Enden der Biegebalkenfeder 135 verbunden sind und der mittlere Verbindungspunkt 140 genau in der Mitte der Biegebalkenfeder 135 liegt. Die Verbindungen 112, 122 zu den Schwingungssystemen 110, 120 liegen dann bei einem Viertel bzw. drei Viertel Länge der Biegebalkenfeder 135 bzw. genau zwischen den jeweiligen Verbindungspunkten 140.

Die Biegebalkenfeder 135 hat dann eine über ihre Länge einheitliche Dicke und kann damit eine einheitliche Federkonstante aufweisen. Durch diesen symmetrischen Aufbau verschieben sich die Schwingungssysteme 110, 120 stets mit gegengleicher Amplitude und Phase, d.h. der Betrag der Auslenkung ist gleich groß und die Richtung der Auslenkung verschieden.

Dieser gegengleiche Lauf der Schwingungssysteme 110, 120 kann aber auch mit einem nicht vollständig symmetrischen Aufbau erreicht werden, wenn eine Biegebalkenfeder mit entsprechend angepasster, über ihre Länge nicht konstanter Federkonstante verwendet wird. Schlussendlich entscheidet die Dimensionierung, Art und Segmentierung der Biegebalkenfeder 135 und damit der Wert der Federkonstante entlang der zweiten Richtung über die Verformung der Biegebalkenfeder 135 bei einer gegebenen Anordnung der Verbindungspunkte 140 und einer gegebenen Kräfteverteilung aufgrund der Auslenkung der Schwingungssysteme 110, 120. Damit ist es möglich, eine gegenläufige Bewegung der Schwingungssysteme 110, 120 für nahezu alle möglichen Anordnungen von Verbindungspunkten 140 zum Substrat 200 und von Verbindungen 112, 122 zu den Schwingungssystemen zu ermöglichen.

Die Verformung der Biegebalkenfeder 135 entspricht idealer Weise einer stehenden Welle, deren Punkte maximaler Auslenkung an den Verbindungen 112, 122 zu den Schwingungssystemen 110, 120 liegen, und sich geradlinig entlang der ersten Richtung bewegen.

Insbesondere kann die Verbindung zwischen Substrat 200, Biegebalkenfeder 135 und Schwingungssystemen 110, 120 derart ausgestaltet sein, dass die erste Eigenmode der so geformten Kopplungsvorrichtung 130 der zweiten Eigenmode einer frei schwingenden Biegebalkenfeder 135 entspricht. Dies bedeutet, dass die Biegebalkenfeder 135 bei einer Anregung nicht einen Schwingungsbauch bildet (erste Eigenmode der freien Biegebalkenfeder), sondern zwei Schwingungsbäuche ausbildet. Anders ausgedrückt schwingen die zwischen den Verbindungspunkten liegenden Segmente der Biegebalkenfeder 135 in der ersten Eigenmode der freien Biegebalkenfeder, die aus den Segmenten zusammengesetzte Biegebalkenfeder 135 damit in der zweiten Eigenmode.

Gemäß der ersten erfindungsgemäßen Lösung wird im Gegensatz zur obigen Beschreibung der in den Fig. 1A und 1B schraffiert gezeigte, mittlere Verbindungspunkt 140 weggelassen. Auch in diesem Fall kann eine Schwingung der Biegebalkenfeder 135 erzeugt werden, die die Schwingungssysteme 110, 120 im Gegentakt koppelt. Dies kann z.B. durch eine entsprechende Platzierung der Verbindungen 112, 122 zwischen Schwingungssystemen 110, 120 und Biegebalkenfeder 135 erfolgen, die das Ausbilden der Schwingungsmode begünstigt, in der jedes Schwingungssystem 110, 120 im Bereich eines Schwingungsbauches mit der Biegebalkenfeder 135 verbunden ist. Zusätzlich oder alternativ können die Schwingungssysteme 110, 120 auch derart im Gegentakt schwingen, dass die Schwingungsfrequenz die Eigenfrequenz einer derartigen Schwingungsmode ist, bzw. ihr naheliegt. Die Verbindungen liegen dabei vorteilhafter Weise im Maximum der Schwingungsbäuche, d.h. an den Punkten maximaler Auslenkung der Biegebalkenfeder 135.

Weiter alternativ können anstatt zweier Schwingungssysteme 110, 120 auch eine Mehrzahl von Schwingungssystemen durch die Biegebalkenfeder 135 gekoppelt sein. Dann müssen Anordnung bzw. Betriebsfrequenz der z.B. N Schwingungssysteme derart sein, dass die Biegebalkenfeder N Schwingungsbäuche im Bereich der jeweiligen Verbindungen zu den Schwingungssystemen ausbildet. Gemäß der ersten erfindungsgemäßen Lösung wird dies durch eine gleichmäßige Verteilung der N Schwingungssysteme entlang der Länge L der Biegebalkenfeder zwischen zwei Verbindungspunkten 140 unterstützt, bei der das n-te Schwingungssystem an der Position (2n-1)·L/2N der Biegebalkenfeder 135 liegt. Benachbarte Schwingungssysteme schwingen dann im Gegentakt. Bei zwei Schwingungssystemen 110, 120 entspricht dies der oben beschriebenen Positionierung bei einem Viertel bzw. drei Viertel der Länge der Biegebalkenfeder zwischen zwei Verbindungspunkten 140. Es ist auch möglich einige der N Positionen frei zu lassen. Dadurch kann eine Kopplung erreicht werden, in der ein Teil von benachbarten Schwingungssystemen im Gleichtakt läuft.

Durch eine im Wesentlichen frei schwingende Biegebalkenfeder 135 kann also eine große Anzahl von Schwingungssystemen in einfacher Weise gekoppelt werden. Andererseits bietet die oben mit Bezug auf die Fig. 1A und 1B beschrieben Variante mit zwischenliegender Verbindung von Biegebalkenfeder 135 und Substrat 200 den Vorteil, dass die gegenläufig koppelnde Schwingungsmode einfacher ausgebildet wird.

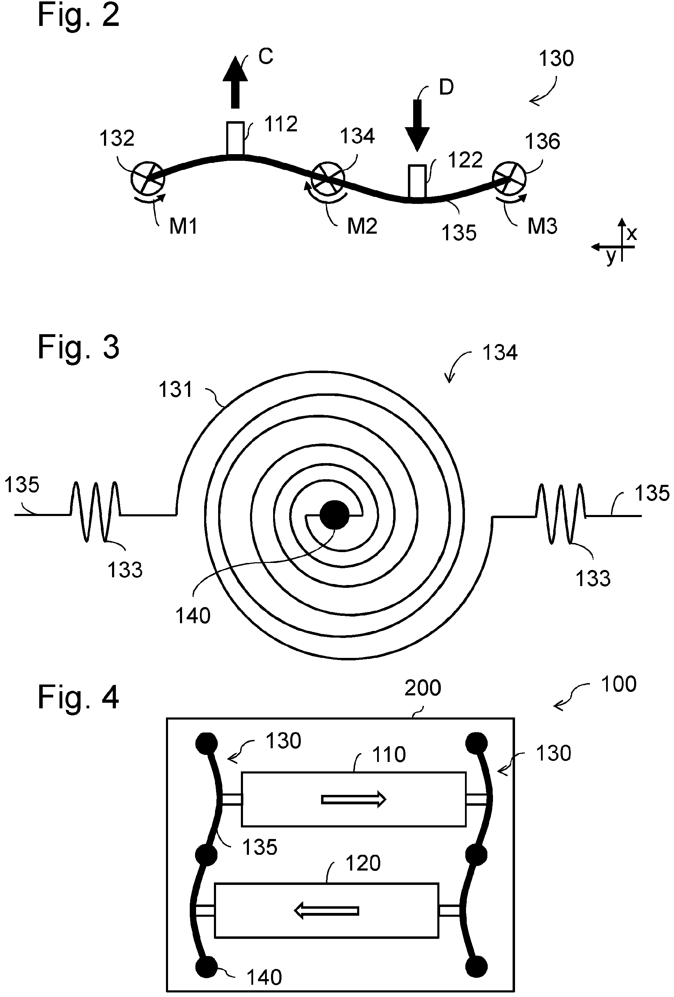

Gemäß der zweiten erfindungsgemäßen Lösung sind bei drei Verbindungen der Biegebalkenfeder 135 zum Substrat 200 diese als Drehfederelemente 132, 134, 136 ausgebildet, wie sie in der Fig. 2 schematisch dargestellt sind. Dies ermöglicht in einfacher Weise eine relative Drehung zwischen Biegebalkenfeder 135 zum Substrat 200, bei gleichzeitig fester Verbindung zum Substrat.

Die Fig. 2 zeigt schematisch die Ausbildung von Drehmomenten und Kräften auf die Drehfederelemente 132, 134, 136 der Kopplungsvorrichtung 130. Ein erstes Drehfederelement 132 ist hierbei mit einem Ende der Biegebalkenfeder 135 verbunden, ein zweites Drehfederelement 134 mit der Mitte der Biegebalkenfeder 135 und ein drittes Drehfederelemente 136 mi dem anderen Ende der Biegebalkenfeder 135. Die Drehfederelemente 132, 134, 136 sitzen also an den Verbindungspunkten 140, die in den Fig. 1A und 1B dargestellt sind. Der Aufbau der Biegebalkenfeder 135 ist hierbei als symmetrisch zum mittleren, zweiten Drehfederelement 134 angenommen.

Die Verbindung 112 zum ersten Schwingungssystem 110 sitzt zwischen dem ersten und dem zweiten Drehfederelement 132, 134, die Verbindung 122 zum zweiten Schwingungssystem 120 zwischen dem zweiten und dem dritten Drehfederelement 134, 136. Bewegt sich das erste Schwingungssystem 110 in die positive x-Richtung wirkt eine entsprechende Kraft auf die Biegebalkenfeder 135. Dies ist in der Fig. 2 mit dem Pfeil C dargestellt. Diese Kraft wird über die Biegebalkenfeder 135 auf das erste und das zweite Drehfederelement 132, 134 weitergegeben und führt dort zu einem Drehmoment, wodurch es zu einer Verdrehung der Drehfederelemente 132, 134 kommt, wie in der Fig. 2 durch drehende Pfeile dargestellt.

In gleicher Weise wirkt vom zweiten Schwingungssystem 120 eine Kraft in negative x-Richtung auf die Biegebalkenfeder 135, in der Fig. 2 mit dem Pfeil D dargestellt. Auch diese Kraft wird auf die benachbarten Drehfederelemente 134, 136 weitergeleitet und verursacht dort ein Drehmoment, das eine Drehung der Drehfederelemente 134, 136 herbeiführt.

Um nun eine gegengleiche Auslenkung der beiden Schwingungssysteme 110, 120 zu gewährleisten, müssen sich sämtliche Drehfederelemente 132, 134, 136 um den gleichen Betrag drehen, da ansonsten die Verbindungen 112, 122 zu den Schwingungssystemen 110, 120 keine gleich großen und geradlinigen Bewegungen mehr ausführen würden. Dies kann dadurch sichergestellt werden, dass die Federkonstanten der Drehfederelemente 132, 134, 136 gegenüber Drehungen gemäß den bei der Auslenkung der Schwingungssysteme 110, 120 auf die Drehfederelemente 132, 134, 136 wirkenden Drehmomente eingestellt werden. Das erste Drehfederelement 132 hat gegenüber Drehungen eine Federkonstante K1, das zweite Drehfederelement 134 eine Federkonstante K2 und das dritte Drehfederelement 136 eine Federkonstante K3. Wenn auf das erste Drehfederelement 132 das Drehmoment M1, auf das zweite Drehfederelement 134 das Drehmoment M2 und auf das dritte Drehfederelement 136 das Drehmoment M3 wirkt, die im Verhältnis M1:M2:M3 stehen, so gilt vorzugsweise K1:K2:K3 = M1:M2:M3. Die Verhältnisse der Drehmomente sind also gleich den Verhältnissen der Federkonstanten gegenüber Drehungen.

Bei einem symmetrischen Aufbau, wie er in der Fig. 2 gezeigt ist, ist das aus den wirkenden Kräften C und D resultierende Drehmoment M2 auf das mittlere Drehfederelement 134 doppelt so groß wie die Drehmomente M1, M3 auf die äußeren Drehfederelemente 132, 136. Im Fall eines symmetrischen Aufbaus der Verbindungen zwischen Substrat 200, Biegebalkenfeder 135 und Schwingungssystemen 110, 120 bietet sich also ein Verhältnis der Federkonstanten von K1:K2:K3 = 1:2:1 an, um eine möglichst lineare und parallele Bewegung der Schwingungssysteme 110, 120 zu erzwingen.

Alternativ kann auch bei einem unsymmetrischen Aufbau durch die Wahl entsprechender Federkonstanten eine lineare Auslenkung der Schwingungssysteme 110, 120 gewährleistet werden.

Wie oben erläutert, sind auch Ausgestaltungen ohne das mittlere Drehfederelement 134 denkbar. Dies hat den Vorteil, dass für eine möglichst gleichmäßige Auslenkung nur die beiden äußeren Drehfederelemente 132, 136 aufeinander abgestimmt werden müssen. Es kann z.B. ausreichend sein, die Federkonstanten gegenüber Drehungen durch identische Ausgestaltung der äußeren Drehfederelemente 132, 136 gleich auszubilden. Dies vereinfacht den Aufbau der Kopplungsvorrichtung 130 weiter.

In den Fig. 1A bis Fig. 2 ist die Verbindung der Biegebalkenfeder 135 mit dem Substrat als punktförmig dargestellt. Dies ist der Fall, wenn die Biegebalkenfeder 135 durchgängig gestaltet ist und in den Verbindungspunkten 140 z.B. durch in sich verdrehbare Pfosten gestützt ist. Aufgrund der Steife der Biegebalkenfeder 135 und des typischen Materials von MEMS-Drehratensensoren, kann die Biegebalkenfeder 135 dann aber nicht sehr weit ausgelenkt werden, ohne beschädigt zu werden.

Alternativ zu einer derartigen punktförmigen Lagerung einer durchgängigen Biegebalkenfeder kann die Biegebalkenfeder 135 an den Verbindungpunkten 140, insbesondere am mittleren Verbindungspunkt 140, auch unterbrochen sein, um ein Drehfederelement 134 einzusetzen, das neben Rotationsbewegungen auch lineare Bewegungen gegenüber dem Substrat 200 durchführen kann. Dadurch lässt sich die Biegebalkenfeder 135 weiter auslenken, da eine Stauchung der Biegebalkenfeder 135 aufgrund der Auslenkung durch eine entsprechende Dehnung des Drehfederelements 134 ausgeglichen werden kann.

Die Fig. 3 ist eine schematische Darstellung eines derartigen Drehfederelements 134. In der Fig. 3 ist die Fähigkeit zur Rotationsbewegung durch die am Verbindungspunkt 140 mit dem Substrat 200 verbundene Spiralfeder 131 dargestellt. Die Möglichkeit zur linearen Bewegung ist durch die beiden Linearfedern 133 dargestellt, an denen sich die Biegebalkenfeder 135 anschließt. Dabei handelt es sich nur um vereinfachte Darstellungen für die Erklärung der Funktion des Drehfederelements 134. Die konkrete Realisierung der entsprechenden Bauteile kann auf vielerlei Arten vorgenommen werden, die einem Fachmann bekannt sind. Insbesondere sind reine Drehfedern und reine Linearfedern im Bereich von MEMS bekannt. Vorteilhaft ist hier die Kombination dieser beiden Prinzipien in einem Drehfederelement 134.

Die Fig. 3 zeigt das Drehfederelement im nicht ausgelenkten Zustand, wie er auch in der Fig. 1A gezeigt ist. Die Spiralfeder 131 ist nicht verdrillt, die Linearfedern 131 sind weder kontrahiert noch gedehnt. Kommt es nun zu einer Auslenkung, wie sie in der Fig. 2 gezeigt ist, dreht sich die Spiralfeder 131 derart um den Verbindungspunkt 140, dass die linke Linearfeder 133 nach oben wandert und die rechte Linearfeder 133 nach unten. Gleichzeitig werden durch das Ausbauchen der Biegebalkenfeder 135 im Bereich der Verbindungen 112, 122 zu den Schwingungssystemen 110, 120 die Linearfedern 133 gedehnt, da die Stauchung der Biegebalkenfeder eine Zugkraft auf das Drehfederelement 134 entstehen lässt.

Durch die Linearfedern 133 - bzw. die Möglichkeit linearer Bewegungen durch das Drehfederelement 134 - wird die Länge der aus mehreren Segmenten zusammengesetzten Biegebalkenfeder 135 variabel. Dadurch können größere Auslenkungen von z.B. mehr als 2 µm, 5 µm, 10 µm, 15 µm oder 20 µm erreicht werden, wodurch sich die Sensitivität des Drehratensensors 100 erhöht.

Derartige Linearfedern zur Längenänderung der Biegebalkenfeder 135 können auch Teil der Biegebalkenfeder 135 sein. Diese weist dann also Abschnitte auf, die sich senkrecht zur eigentlichen Hauptauslenkungsrichtung, d.h. senkrecht zur x-Richtung, verformen können, wie z.B. Gabelungen der Biegebalkenfeder 135 und/oder parallel laufende Abschnitte der Biegebalkenfeder 135.

Durch das Unterteilen der Biegebalkenfeder 135 in mehrere durch Drehfederelemente 134 getrennte Segmente kann die Schwingungsform der Biegebalkenfeder 135 von der einer stehenden Welle abweichen. Um dies zu verhindern, ist es vorteilhaft, die Drehfederelemente 134 möglichst klein auszugestalten, z.B. mit einer Größe kleiner als 1000 µm, 500 µm ,150 µm, 100 µm, 50 µm, 30 µm, 10 µm, oder 5 µm aufweisen. Als Größe der Drehfederelemente 134 kann man hierbei den Durchmesser eines Kreises definieren, in den das Drehfederelement 134 eingepasst werden kann oder den Abstand zwischen den durch das Drehfederelement 134 verbundenen Segmenten der Biegebalkenfeder 135.

Ebenso wie die Drehfederelemente 132, 134, 136 können auch die Verbindungen 112, 122 zu den Schwindungssystemen 110, 120 der Schwingung der Biegebalkenfeder 135 in Form einer stehenden Welle hinderlich sein. Deshalb ist es vorteilhaft, wenn die Breite der Verbindungen 112, 122 in y-Richtung kleiner als 250 µm, 200 µm, 150 µm, 100 µm, 50 µm, 30 µm, 10 µm, 5 µm oder 1 µm ist, um eine möglichst geradlinige Bewegung der Biegebalkenfeder 135 im Bereich der Verbindungen 112, 122 zu gewährleisten.

Neben der in den Fig. 1A und 1B dargestellten Kopplungsvorrichtung 130 kann der Drehratensensor 100 einen weitere Kopplungsvorrichtung 130 aufweisen, die vollkommen analog zur zuvor beschriebenen Kopplungsvorrichtung 130 aufgebaut ist. Dies ist schematisch in der Fig. 4 gezeigt.

Das erste und das zweite Schwingungssystem 110, 120 befinden sich hierbei in x-Richtung zwischen den beiden Kopplungsvorrichtungen 130, die sich beide in y-Richtung erstrecken. Die Schwingungssysteme 110, 120 werden also an ihren beiden Enden von den Kopplungsvorrichtungen 130 geführt, wodurch die Linearität und Parallelität der Bewegung weiter verbessert werden kann.

In den Fig. 1A, 1B und 4 ist die Bewegung der Schwingungssysteme 110, 120 derart dargestellt, dass das erste Schwingungssystem 110 und das zweite Schwingungssystem 120 stets den gleichen äußeren Umfang haben, der sich mit Bezug auf das Substrat 200 verschiebt. Wie oben bereits erwähnt ist dies nur eine vereinfachte Darstellung, die nicht den Verhältnissen in einer tatsächlichen Realisierung entsprechen muss. Die gleichen Auslenkungen für beide Kopplungsvorrichtungen 130 in der Fig. 4 ist dementsprechend ebenfalls als rein schematisch zu verstehen. Auf gleicher Höhe in y-Richtung liegende Abschnitte der Kopplungsvorrichtungen 130 müssen nicht zwangsweise genau die gleiche Auslenkung aufweisen, wenn die Geometrie der Schwingungssysteme 110, 120 etwas anderes erfordert. Ausschlaggebend ist, dass die Kopplungsvorrichtungen 130 die Schwingungssysteme 110, 120 zu entgegengesetzter Bewegung in der x-Richtung zwingen.

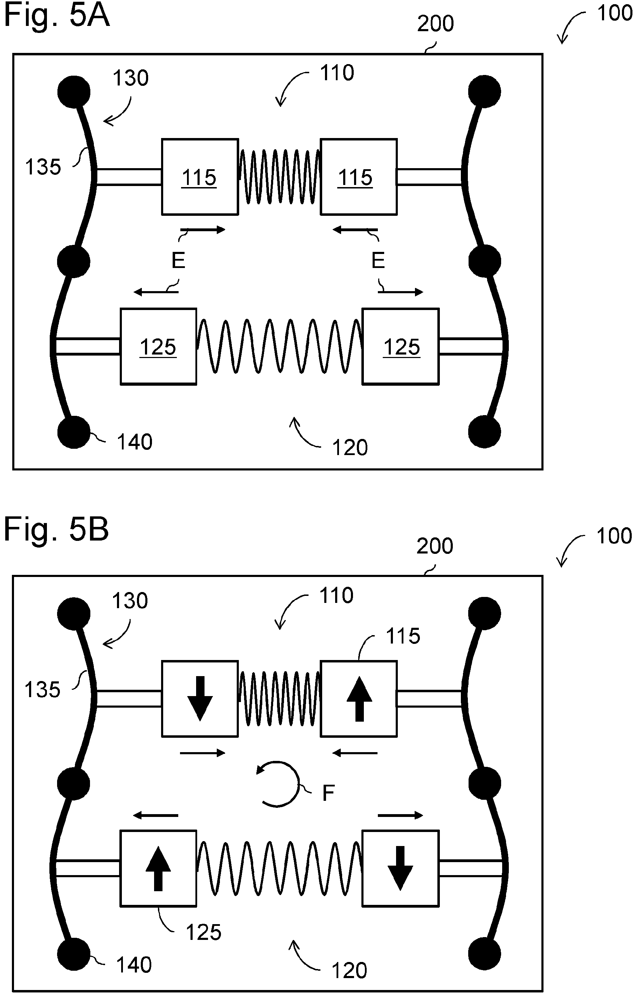

Die Fig. 5A und 5B zeigen eine Ausgestaltung der Schwingungssysteme 110, 120, die in Quad-Mass-Sensoren zum Einsatz kommen kann. Hier weist das erste Schwingungssystem 110 zwei Massen 115 auf, die gegeneinander im Gegentakt entlang der x-Richtung schwingen. Ebenso weist das zweite Schwingungssystem zwei Massen 125 auf, die gegeneinander im Gegentakt entlang der x-Richtung schwingen. Das erste Schwingungssystem 110 und das zweite Schwingungssystem 120 bilden jedes für sich Dual-Mass-Sensoren, deren Kopplung und detaillierter Aufbau einem Fachmann bekannt sind und hier nicht weiter erläutert werden müssen.

Vorteilhaft bei der Verwendung von Dual-Mass-Sensoren, wie sie in den Fig. 5A und 5B gezeigt sind, ist, dass sich durch die Schwingungen hervorgerufene Kräfte, wie etwa Federkräfte, innerhalb des Dual-Mass-Sensors kompensieren, d.h. für jede Kraft gibt es eine gleich große, aber entgegen gerichtete Kraft.

Jedoch ist nicht ausgeschlossen, dass es aufgrund der wirkenden Kräfte Drehmomente gibt, die sich nicht vollständig kompensieren. Um dieses Problem zu lösen schwingen die Massen 115 des ersten Schwingungssystems 110 und die Massen 125 des zweiten Schwingungssystems 120 ebenfalls im Gegentakt. Bewegen sich die Massen 115 des ersten Schwingungssystems 110 nach innen, führen die Massen 125 des zweiten Schwingungssystems 120 eine Bewegung nach außen aus und umgekehrt, wie in der Fig. 5A durch die Pfeile E gekennzeichnet.

Der Vorteil dieser Anordnung kann der Fig. 5B entnommen werden. Unterliegt der Drehratensensor 100 einer Drehung um eine Achse senkrecht zur Bildebene (durch den Pfeil F in der Fig. 5B symbolisiert), wirkt auf die Massen 115, 125 eine Corioliskraft. Wie in der Fig. 5B schematisch dargestellt ist diese für Drehungen entgegen des Uhrzeigersinns für nach rechts laufende Massen nach unten gerichtet und für nach links laufende Massen nach oben. Die entstehende Corioliskraft kann gemessen werden indem z.B. die Ablenkung der Massen von der rein linearen Bewegung durch Kondensatoren erfasst wird oder indem über einen Regelkreis die elektrische Spannung festgestellt wird, mit denen Kondensatoren beaufschlagt werden müssen, um eine Abweichung von der linearen Bewegung in x-Richtung zu vermeiden. Dies genaue Art der Ermittlung der Corioliskraft und die daraus erfolgende Ableitung der Drehrate sind an sich bekannt und brauchen hier nicht weiter erörtert zu werden.

Da sich die jeweiligen Massen 115, 125 eines Schwingungssystems 110, 120 links und rechts vom Zentrum des Schwingungssystems 110, 120 befinden, generieren die auf die beiden Massen wirkenden Kräfte gleich gerichtete Drehmomente. Ein einzelnes Schwingungssystem bzw. ein einzelner Dual-Mass-Sensor ist daher zwar kräftefrei, aber nicht ohne weiteres momentfrei.

Die Schwingungssysteme 110, 120 in der Quad-Mass-Anordnung der Fig. 5A und 5B sind identisch aufgebaut und schwingen im Gegentakt. Die durch die Corioliskraft in den beiden Schwingungssystemen 110, 120 hervorgerufenen Drehmomente sind also (bei zeitlicher Mittelung über eine Schwingungsperiode) genau gegengleich, d.h. vom gleichen Betrag aber von entgegengesetzter Richtung. Dadurch sind Quad-Mass-Sensoren kräfte- und drehmomentenfrei.

Dies wird aber nur für eine im Wesentlichen parallele und geradlinige Schwingung der Massen 115, 125 der beiden Schwingungssysteme 110, 120 erreicht. Aus diesem Grund ist die Verwendung von Kopplungsvorrichtungen 130, wie sie oben beschrieben wurden, für Quad-Mass-Sensoren besonders vorteilhaft, da diese in der Lage sind, beide Schwingungssysteme 110, 120 auf die vorteilhaften parallelen und linearen Bahnen zu zwingen. Insbesondere die Verwendung von Biegebalkenfedern 135, die mit den oben beschriebenen Drehfederelementen 132, 134, 136 derart verbunden sind, dass die Biegebalkenfeder 125 bei Anregung der Schwingungen der Schwingungssysteme 110, 120 in Form einer stehenden Welle schwingt, ist vorteilhaft, da dann die Schwingungssysteme 110, 120 in den Maxima der stehende Welle geführt werden können, die sich ausschließlich entlang der x-Richtung bewegen. Auf diese Weise können robuste, verlässliche und hochpräzise Drehratensensoren 100 bereitgestellt werden.

## Patentansprüche

1. Mikro-elektro-mechanische Komponente, vorzugsweise Inertialsensor, weiter vorzugsweise Drehratensensor (100) zum Messen einer Drehung des Drehratensensors (100), aufweisend:
eine Kopplungsvorrichtung (130) zum Koppeln einer Mehrzahl von Schwingungssystemen (110, 120), die derart über einem Substrat (200) gelagert sind, dass sie entlang einer ersten Richtung (x) schwingen können und zueinander in einer zur ersten Richtung (x) senkrechten zweiten Richtung (y) versetzt sind, wobei die Kopplungsvorrichtung eine in die erste Richtung (x) biegbare Biegebalkenfeder (135) aufweist, die mit den Schwingungssystemen (110, 120) verbunden ist und Verbindungen (112, 122) der Biegebalkenfeder (135) mit den Schwingungssystemen (110, 120) derart zwischen zwei Verbindungspunkten (140) der Biegebalkenfeder (135) mit dem Substrat (200) angeordnet sind, dass eine durch Bewegungen der Schwingungssysteme (110, 120) hervorgerufene Auslenkung der Biegebalkenfeder (135) zu einer Schwingung der Biegebalkenfeder (135) mit Schwingungsbäuchen im Bereich der Verbindungen (112, 122) der Biegebalkenfeder (135) mit den Schwingungssystemen (110, 120) führt; und
die Mehrzahl der Schwingungssysteme (110, 120), wobei die Anzahl der Schwingungssysteme (110, 120) N beträgt, und wobei
eine Länge der Biegebalkenfeder (135) zwischen zwei Verbindungspunkten (140) zum Substrat (200) L beträgt, **dadurch gekennzeichnet, dass** keine weiteren Verbindungspunkte zum Substrat (200) zwischen den besagten zwei Verbindungspunkten (140) liegen; und
das Schwingungssystem n (n=1,...,N) bei (2n-1)·L/2N mit der Biegebalkenfeder (135) verbunden ist.

2. Mikro-elektro-mechanische Komponente, vorzugsweise Inertialsensor, weiter vorzugsweise Drehratensensor (100) zum Messen einer Drehung des Drehratensensors (100), aufweisend:
eine Kopplungsvorrichtung (130) zum Koppeln einer Mehrzahl von Schwingungssystemen (110, 120), die derart über einem Substrat (200) gelagert sind, dass sie entlang einer ersten Richtung (x) schwingen können und zueinander in einer zur ersten Richtung (x) senkrechten zweiten Richtung (y) versetzt sind, wobei die Kopplungsvorrichtung eine in die erste Richtung (x) biegbare Biegebalkenfeder (135) aufweist, die mit den Schwingungssystemen (110, 120) verbunden ist und Verbindungen (112, 122) der Biegebalkenfeder (135) mit den Schwingungssystemen (110, 120) derart zwischen zumindest zwei Verbindungspunkten (140) der Biegebalkenfeder (135) mit dem Substrat (200) angeordnet sind, dass eine durch Bewegungen der Schwingungssysteme (110, 120) hervorgerufene Auslenkung der Biegebalkenfeder (135) zu einer Schwingung der Biegebalkenfeder (135) mit Schwingungsbäuchen im Bereich der Verbindungen (112, 122) der Biegebalkenfeder (135) mit den Schwingungssystemen (110, 120) führt; und
ein erstes Schwingungssystem (110) und ein zweites Schwingungssystem (120); wobei
die Kopplungsvorrichtung (130) an drei Verbindungspunkten (140) mit dem Substrat (200) verbunden ist und zwischen einem Paar von benachbarten Verbindungspunkten (140) mit dem ersten Schwingungssystem (110) verbunden ist und zwischen dem anderen Paar von benachbarten Verbindungspunkten (140) mit dem zweiten Schwingungssystem (120) verbunden ist,
**dadurch gekennzeichnet, dass**
die Kopplungsvorrichtung (130) des Weiteren ein erstes, ein zweites und ein drittes Drehfederelement (132, 134, 136) aufweist;
das erste Drehfederelement (132) ein erstes Ende der Biegebalkenfeder (135), das zweite Drehfederelement (134) die Mitte der Biegebalkenfeder (135) und das dritte Drehfederelement (136) ein zweites Ende der Biegebalkenfeder (135) mit dem Substrat (200) verbindet;
das erste Schwingungssystem (110) in der Mitte zwischen erstem und zweitem Drehfederelement (132, 134) mit der Biegebalkenfeder (135) verbunden ist und das zweite Schwingungssystem (120) in der Mitte zwischen zweitem und drittem Drehfederelement (134, 136) mit der Biegebalkenfeder (135) verbunden ist; und
sich bei einer gegenläufigen Auslenkung des ersten und zweiten Schwingungssystems (110, 120) entlang der ersten Richtung (x) die zweite Eigenmode der Biegebalkenfeder (135) als erste Eigenmode der Kopplungsvorrichtung (130) ausbildet und dadurch das erste und zweite Schwingungssystem (110, 120) zu der parallelen Bewegung zwingt.

3. Mikro-elektro-mechanische Komponente gemäß Anspruch 2, wobei
die Kopplungsvorrichtung (130) bei gegenläufigen Schwingungen des ersten Schwingungssystems (110) und des zweiten Schwingungssystems (120) entlang der ersten Richtung (x) diese zu einer Bewegung im Gegentakt, vorzugsweise zu einer parallelen Bewegung, zwingt.

4. Mikro-elektro-mechanische Komponente nach einem der Ansprüche 2 bis 3, wobei
die Kopplungsvorrichtung (130) das erste und das zweite Schwingungssystem (110, 120) zu Schwingungen mit betragsmäßig gleich großer, aber entgegengesetzter Amplitude und Phase zwingt.

5. Mikro-elektro-mechanische Komponente nach einem der Ansprüche 2 bis 4, wobei
die Bewegung der Biegebalkenfeder (135) einer stehenden Welle mit fixen Endpunkten und fixem Mittelpunkt entspricht.

6. Mikro-elektro-mechanische Komponente nach einem der Ansprüche 2 bis 5, wobei
bei gegenläufiger Auslenkung des ersten und des zweiten Schwingungssystems (110, 120) ein erstes Drehmoment M1 an dem ersten Drehfederelement (132), ein zweites Drehmoment M2 an dem zweiten Drehfederelement (134) und ein drittes Drehmoment M3 an dem dritte Drehfederelement (136) anliegt;
das erste Drehfederelement (132) eine erste Federkonstante K1 gegenüber Drehungen, das zweite Drehfederelement (134) eine zweite Federkonstante K2 gegenüber Drehungen und das dritte Drehfederelement (136) eine dritte Federkonstante K3 gegenüber Drehungen aufweist; und
die Beziehung gilt: M1:M2:M3 = F1:F2:F3.

7. Mikro-elektro-mechanische Komponente nach einem der Ansprüche 2 bis 6, wobei
das erste und dritte Drehfederelement (132, 136) die gleiche Federkonstante K1 = K3 gegenüber Drehungen aufweisen; und
das zweite Drehfederelement (134) eine Federkonstante K2 gegenüber Drehungen aufweist, die doppelt so groß ist, wie die Federkonstante des ersten und des dritten Drehfederelements (132, 136), d.h. es gilt K1:K2:K3 = 1:2:1.

8. Mikro-elektro-mechanische Komponente nach einem der Ansprüche 2 bis 7, wobei
die Drehfederelemente (132, 134, 136) sowohl gegenüber dem Substrat (200) verdreht als auch linear gegenüber dem Substrat (200) bewegt werden können.

9. Mikro-elektro-mechanische Komponente nach einem der Ansprüche 2 bis 8, wobei
die Drehfederelemente (132, 134, 136) eine Größe von weniger als 1000 µm, 500 µm, 150 µm, 100 µm, 50 µm, 30 µm, 10 µm, oder 5 µm aufweisen.

10. Mikro-elektro-mechanische Komponente nach einem der Ansprüche 2 bis 9, wobei
Verbindungen (112, 122) zwischen dem ersten und dem zweiten Schwingungssystem (110, 120) und der Kopplungsvorrichtung (130) entlang der zweiten Richtung (y) eine Breite aufweisen, die kleiner als 250 µm, 200 µm, 150 µm, 100 µm, 50 µm, 30 µm, 10 µm, 5 µm oder 1 µm ist.

11. Mikro-elektro-mechanische Komponente nach einem der Ansprüche 2 bis 10, des Weiteren aufweisend:
eine weitere Kopplungsvorrichtung (130), die identisch zu der Kopplungsvorrichtung (130) aufgebaut ist; wobei
das erste und das zweite Schwingungssystem (110, 120) entlang der ersten Richtung (x) zwischen den beiden Kopplungsvorrichtungen (130) angeordnet sind und die beiden Kopplungsvorrichtungen (130) in gleicher Weise mit dem ersten und dem zweiten Schwingungssystem (110, 120) verbunden sind.

12. Mikro-elektro-mechanische Komponente nach einem der Ansprüche 2 bis 11, wobei
das erste und das zweite Schwingungssystem (110, 120) jeweils zwei Massen (115, 125) aufweisen, die entlang der ersten Richtung (x) zu gegenläufigen Schwingungen angeregt werden können;
eine Drehung bei angeregter Schwingung entlang der ersten Richtung (x) eine auf die Massen (115, 125) wirkende Corioliskraft entlang der zweiten Richtung (y) auslöst, deren Größe gemessen werden kann, um auf die Drehrate zu schließen; und
das erste und das zweite Schwingungssystem (110, 120) einen identischen und symmetrischen Aufbau haben, aufgrund dessen die mikro-elektro-mechanische Komponente als Ganzes bei angeregten Schwingungen der Massen (115, 125) im zeitlichen Mittel kräfte- und drehmomentenfrei ist.

## Claims

1. A micro-electro-mechanical component, preferably an inertial sensor, more preferably a rotation rate sensor (100) for measuring a rotation of the rotation rate sensor (100), comprising:
a coupling device (130) for coupling a plurality of vibration systems (110, 120), which are mounted above a substrate (200) in such a manner that said systems can vibrate along a first direction (x) and are offset with respect to one another in a second direction (y) perpendicular to the first direction (x), wherein the coupling device has a bending beam spring (135) which can bend in the first direction (x) and is connected to the vibration systems (110, 120), and connections (112, 122) of the bending beam spring (135) to the vibration systems (110, 120) are arranged between two connection points (140) of the bending beam spring (135) to the substrate (200) in such a manner that a deflection of the bending beam spring (135) which is caused by movements of the vibration systems (110, 120) results in a vibration of the bending beam spring (135) with vibration antinodes in the area of the connections (112, 122) of the bending beam spring (135) to the vibration systems (110, 120); and
the plurality of vibration systems (110, 120), wherein
the number of vibration systems (110, 120) is N, and wherein
a length of the bending beam spring (135) between two connection points (140) to the substrate (200) is L, **characterized in that**
there are no further connection points to the substrate (200) between said two connection points (140); and
the vibration system n (n=1, ...,N) is connected to the bending beam spring (135) at (2n-1)·L/2N.

2. The micro-electro-mechanical component, preferably an inertial sensor, more preferably a rotation rate sensor (100) for measuring a rotation of the rotation rate sensor (100), comprising:
a coupling device (130) for coupling a plurality of vibration systems (110, 120), which are mounted above a substrate (200) in such a manner that said systems can vibrate along a first direction (x) and are offset with respect to one another in a second direction (y) perpendicular to the first direction (x), wherein the coupling device has a bending beam spring (135) which can bend in the first direction (x) and is connected to the vibration systems (110, 120), and connections (112, 122) of the bending beam spring (135) to the vibration systems (110, 120) are arranged between at least two connection points (140) of the bending beam spring (135) to the substrate (200) in such a manner that a deflection of the bending beam spring (135) which is caused by movements of the vibration systems (110, 120) results in a vibration of the bending beam spring (135) with vibration antinodes in the area of the connections (112, 122) of the bending beam spring (135) to the vibration systems (110, 120); and
a first vibration system (110) and a second vibration system (120); wherein
the coupling device (130) is connected to the substrate (200) at three connection points (140) and is connected to the first vibration system (110) between one pair of adjacent connection points (140) and is connected to the second vibration system (120) between the other pair of adjacent connection points (140),
**characterized in that**
the coupling device (130) further includes first, second and third torsion spring elements (132, 134, 136);
the first torsion spring element (132) connects a first end of the bending beam spring (135), the second torsion spring element (134) connects the center of the bending beam spring (135), and the third torsion spring element (136) connects a second end of the bending beam spring (135) to the substrate (200);
the first vibration system (110) is connected to the bending beam spring (135) midway between the first and second torsion spring elements (132, 134), and the second vibration system (120) is connected to the bending beam spring (135) midway between the second and third torsion spring elements (134, 136); and
in the case of an opposite direction deflection of the first and second vibration systems (110, 120) along the first direction (x), the second mode of the bending beam spring (135) forms as the first mode of the coupling device (130), thereby forcing the first and second vibration systems (110, 120) to move in parallel.

3. The micro-electro-mechanical component according to claim 2, wherein,
in the case of opposite direction vibrations of the first vibration system (110) and the second vibration system (120) along the first direction (x), the coupling device (130) forces them to move in push-pull mode, preferably, in parallel.

4. The micro-electro-mechanical component according to any one of claims 2 to 3, wherein
the coupling device (130) forces the first and second vibration systems (110, 120) to vibrate with amplitudes and phases equal in magnitude, but in opposite directions.

5. The micro-electro-mechanical component according to any one of claims 2 to 4, wherein
the movement of the bending beam spring (135) corresponds to a stationary wave with fixed end points and a fixed center point.

6. The micro-electro-mechanical component according to any one of claims 2 to 5, wherein,
in the case of an opposite direction deflection of the first and second vibration systems (110, 120), a first torque M1 abuts the first torsion spring element (132), a second torque M2 abuts the second torsion spring element (134), and a third torque M3 abuts the third torsion spring element (136);
the first torsion spring element (132) includes a first spring constant K1 with respect to rotations, the second torsion spring element (134) includes a second spring constant K2 with respect to rotations, and the third torsion spring element (136) includes a third spring constant K3 with respect to rotations; and
the following relationship applies: M1:M2:M3 = F1:F2:F3.

7. The micro-electro-mechanical component according to any one of claims 2 to 6, wherein
the first and third torsion spring elements (132, 136) have the same spring constant K1 = K3 with respect to rotations; and
the second torsion spring element (134) has a spring constant K2 with respect to rotations which is twice as large as the spring constant of the first and third torsion spring elements (132, 136), i.e., K1:K2:K3 = 1:2:1 applies.

8. The micro-electro-mechanical component according to any one of claims 2 to 7, wherein
the torsion spring elements (132, 134, 136) can be twisted with respect to the substrate (200), as well as moved linearly with respect to the substrate (200).

9. The micro-electro-mechanical component according to any one of claims 2 to 8, wherein
the torsion spring elements (132, 134, 136) have a size of less than 1000µm, 500µm, 150µm, 100µm, 50µm, 30µm, 10µm or 5µm.

10. The micro-electro-mechanical component according to any one of claims 2 to 9, wherein
connections (112, 122) between the first and second vibration systems (110, 120) and the coupling device (130) along the second direction (y) have a width that is less than 250µm, 200µm, 150µm, 100µm, 50µm, 30µm, 10µm, 5µm or 1µm.

11. The micro-electro-mechanical component according to any one of claims 2 to 10, further comprising:
an additional coupling device (130) which is identical in construction to the coupling device (130); wherein
the first and second vibration systems (110, 120) are arranged between the two coupling devices (130) along the first direction (x), and the two coupling devices (130) are connected to the first and second vibration systems (110, 120) in the same manner.

12. The micro-electro-mechanical component according to any one of claims 2 to 11, wherein
the first and second vibration systems (110, 120) each have two masses (115, 125) that can be initiated to vibrate in opposite directions along the first direction (x);
a rotation with vibration initiated along the first direction (x) releases a Coriolis force acting on the masses (115, 125) along the second direction (y), the magnitude of which can be measured to infer the rate of rotation; and
the first and second vibration systems (110, 120) have an identical and symmetrical structure, due to which the micro-electro-mechanical component as a whole is free of force and torque in the time average with the initiation of the vibrations of the masses (115, 125).

## Revendications

1. Composant microélectromécanique, de préférence capteur inertiel, de manière plus préférée capteur de vitesse de rotation (100) pour mesurer une rotation du capteur de vitesse de rotation (100), présentant :
un dispositif de couplage (130) pour coupler une pluralité de systèmes d'oscillation (110, 120) qui sont montés au-dessus d'un substrat (200) de telle sorte qu'ils puissent osciller le long d'une première direction (x) et soient décalés les uns des autres dans une deuxième direction (y), perpendiculaire à la première direction (x), dans lequel le dispositif de couplage présente un ressort à barre flexible (135) pouvant fléchir dans la première direction (x) qui est relié aux systèmes d'oscillation (110, 120) et les liaisons (112, 122) du ressort à barre flexible (135) aux systèmes d'oscillation (110, 120) sont disposées entre deux points de liaison (140) du ressort à barre flexible (135) au substrat (200) de telle sorte qu'une déviation du ressort à barre flexible (135) provoquée par les mouvements des systèmes d'oscillation (110, 120) entraîne une oscillation du ressort à barre flexible (135) comprenant des ventres d'oscillation dans la zone des liaisons (112, 122) du ressort à barre flexible (135) aux systèmes d'oscillation (110, 120) ; et
la pluralité des systèmes d'oscillation (110, 120), dans lequel
le nombre des systèmes d'oscillation (110, 120) est égal à N, et dans lequel
une longueur du ressort à barre flexible (135) entre deux points de liaison (140) par rapport au substrat (200) est égale à L, **caractérisé en ce que**
aucun autre point de liaison par rapport au substrat (200) ne se situe entre lesdits deux points de liaison (140) ; et
le système d'oscillation n (n=1,..., N) est relié au ressort à barre flexible (135) pour (2n-1)-L/2N.

2. Composant microélectromécanique, de préférence capteur inertiel, de manière plus préférée capteur de vitesse de rotation (100) pour mesurer une rotation du capteur de vitesse de rotation (100), présentant :
un dispositif de couplage (130) pour coupler une pluralité de systèmes d'oscillation (110, 120) qui sont montés au-dessus d'un substrat (200) de telle sorte qu'ils puissent osciller le long d'une première direction (x) et sont décalés les uns des autres dans une deuxième direction (y), perpendiculaire à la première direction (x), dans lequel le dispositif de couplage présente un ressort à barre flexible (135) pouvant fléchir dans la première direction (x) qui est relié aux systèmes d'oscillation (110, 120) et les liaisons (112, 122) du ressort à barre flexible (135) aux systèmes d'oscillation (110, 120) sont disposées entre au moins deux points de liaison (140) du ressort à barre flexible (135) au substrat (200) de telle sorte qu'une déviation du ressort à barre flexible (135) provoquée par les mouvements des systèmes d'oscillation (110, 120) entraîne une oscillation du ressort à barre flexible (135) comprenant des ventres d'oscillation dans la zone des liaisons (112, 122) du ressort à barre flexible (135) aux systèmes d'oscillation (110, 120) ; et
un premier système d'oscillation (110) et un deuxième système d'oscillation (120) ; dans lequel
le dispositif de couplage (130) est relié au substrat (200) en trois points de liaison (140) et est relié au premier système d'oscillation (110) entre une paire de points de liaison (140) voisins et est relié au deuxième système d'oscillation (120) entre l'autre paire de points de liaison (140) voisins,
**caractérisé en ce que**
le dispositif de couplage (130) présente en outre un premier, un deuxième et un troisième élément ressort de torsion (132, 134, 136) ;
le premier élément ressort de torsion (132) relie une première extrémité du ressort à barre flexible (135), le deuxième élément ressort de torsion (134) le centre du ressort à barre flexible (135) et le troisième élément ressort de torsion (136) une deuxième extrémité du ressort à barre flexible (135) au substrat (200) ;
le premier système d'oscillation (110) est relié au ressort à barre flexible (135) à mi-chemin entre le premier et le deuxième élément ressort de torsion (132, 134) et le deuxième système d'oscillation (120) est relié au ressort à barre flexible (135) à mi-chemin entre le deuxième et le troisième élément ressort de torsion (134, 136) ; et
lors d'une déviation en sens contraires du premier et deuxième système d'oscillation (110, 120) le long de la première direction (x), le deuxième mode propre du ressort à barre flexible (135) se réalise en tant que premier mode propre du dispositif de couplage (130) et contraint ainsi le premier et deuxième système d'oscillation (110, 120) au mouvement parallèle.

3. Composant microélectromécanique selon la revendication 2, dans lequel
lors d'oscillations en sens contraires du premier système d'oscillation (110) et du deuxième système d'oscillation (120) le long de la première direction (x), le dispositif de couplage (130) contraint ceux-ci à se déplacer de manière symétrique, de préférence à se déplacer de manière parallèle.

4. Composant microélectromécanique selon l'une des revendications 2 à 3, dans lequel
le dispositif de couplage (130) contraint le premier et le deuxième système d'oscillation (110, 120) à osciller avec une amplitude et une phase aussi grandes en valeur, mais opposées.

5. Composant microélectromécanique selon l'une des revendications 2 à 4, dans lequel
le mouvement du ressort à barre flexible (135) correspond à une onde stationnaire avec des points d'extrémité fixes et un point central fixe.

6. Composant microélectromécanique selon l'une des revendications 2 à 5, dans lequel
lors d'une déviation en sens inverses du premier et du deuxième système d'oscillation (110, 120), un premier couple M1 s'applique sur le premier élément ressort de torsion (132), un deuxième couple M2 sur le deuxième élément ressort de torsion (134) et un troisième couple M3 sur le troisième élément ressort de torsion (136) ;
le premier élément ressort de torsion (132) présente une première constante de rappel K1 par rapport aux rotations, le deuxième élément ressort de torsion (134) une deuxième constante de rappel K2 par rapport aux rotations et le troisième élément ressort de torsion (136) une troisième constante de rappel K3 par rapport aux rotations ; et
la relation : M1:M2:M3 = F1:F2:F3 s'applique.

7. Composant microélectromécanique selon l'une des revendications 2 à 6, dans lequel
le premier et troisième élément ressort de torsion (132, 136) présente la même constante de rappel K1 = K3 par rapport aux rotations ; et
le deuxième élément ressort de torsion (134) présente une constante de rappel K2 par rapport aux rotations qui est deux fois plus grande que la constante de rappel du premier et du troisième élément ressort de torsion (132, 136), ce qui signifie que K1:K2:K3 = 1:2:1 s'applique.

8. Composant microélectromécanique selon l'une des revendications 2 à 7, dans lequel
les éléments ressorts de torsion (132, 134, 136) peuvent être aussi bien amenés en torsion par rapport au substrat (200) que déplacés linéairement par rapport au substrat (200).

9. Composant microélectromécanique selon l'une des revendications 2 à 8, dans lequel
les éléments ressorts de torsion (132, 134, 136) présentent une taille inférieure à 1000 µm, 500 µm, 150 µm, 100 µm, 50 µm, 30 µm, 10 µm, ou 5 µm.

10. Composant microélectromécanique selon l'une des revendications 2 à 9, dans lequel
les liaisons (112, 122) entre le premier et le deuxième système d'oscillation (110, 120) et le dispositif de couplage (130) le long de la deuxième direction (y) présentent une largeur qui est inférieure à 250 µm, 200 µm, 150 µm, 100 µm, 50 µm, 30 µm, 10 µm, 5 µm ou est de 1 µm.

11. - Composant microélectromécanique selon l'une des revendications 2 à 10, présentant en outre :
un autre dispositif de couplage (130) qui est conçu de manière identique au dispositif de couplage (130) ; dans lequel
le premier et le deuxième système d'oscillation (110, 120) sont disposés le long de la première direction (x) entre les deux dispositifs de couplage (130) et les deux dispositifs de couplage (130) sont reliés de la même manière au premier et au deuxième système d'oscillation (110, 120).

12. Composant microélectromécanique selon l'une des revendications 2 à 11, dans lequel
le premier et le deuxième système d'oscillation (110, 120) présentent respectivement deux masses (115, 125) qui peuvent être amenées à osciller en sens contraires le long de la première direction (x) ;
une rotation lors d'une d'oscillation engendrée le long de la première direction (x) déclenche une force de Coriolis agissant sur les masses (115, 125) le long de la deuxième direction (y) dont la grandeur peut être mesurée afin de déduire la vitesse de rotation ; et
le premier et le deuxième système d'oscillation (110, 120) possèdent une conception identique et symétrique, en raison de laquelle le composant microélectromécanique n'est dans l'ensemble en moyenne temporelle soumis ni à une force ni à un couple lorsque les oscillations des masses (115, 125) sont engendrées.
